# EUROPÄISCHE PATENTSCHRIFT

(11) **EP 2 205 950 B1**
(45) Veröffentlichungstag und Bekanntmachung des Hinweises auf die Patenterteilung: **15.01.2014**
(21) Anmeldenummer: 08802708.1
(22) Anmeldetag: 29.09.2008
(51) Int. Cl.: G01J 5/10, G01J 5/12, G01J 5/34, H01L 27/16, H01L 31/101, H01L 37/00

(54) **VORRICHTUNG ZUR DETEKTION VON WÄRMESTRAHLUNG MIT HOHER AUFLÖSUNG UND VERFAHREN ZU DEREN HERSTELLUNG**
DEVICE FOR DETECTING HEAT RADIATION WITH HIGH RESOLUTION AND METHOD FOR THE PRODUCTION THEREOF
DISPOSITIF DE DÉTECTION D'UN RAYONNEMENT THERMIQUE À HAUTE RÉSOLUTION ET SON PROCÉDÉ DE PRODUCTION

(30) Priorität: 28.09.2007 DE 102007046451
(43) Veröffentlichungstag der Anmeldung: 14.07.2010
(73) Patentinhaber: Pyreos Ltd., EH9 3JF Edinburgh (GB)
(72) Erfinder: GIEBELER, Carsten, Edinburgh EH4 6HD (GB); RETTIG, Uwe, 85521 Ottobrunn (DE); SCHREITER, Matthias, 81379 München (DE)
(74) Vertreter: Fischer, Ernst
(86) Internationale Anmeldenummer: PCT/EP2008/008280
(87) Internationale Veröffentlichungsnummer: WO 2009/043571

(56) Entgegenhaltungen:
- WO-A-2004/020960
- US-A1- 2004 113 076

## Beschreibung

Die Erfindung betrifft eine Vorrichtung zur Detektion von Wärmestrahlung. Neben der Vorrichtung werden ein Verfahren zur Herstellung der Vorrichtung und eine Verwendung der Vorrichtung angegeben.

Eine Vorrichtung zur Detektion von Wärmestrahlung ist beispielsweise aus DE 100 04 216 A1 bekannt. Diese Vorrichtung wird als Pyrodetektor bezeichnet. Das Detektorelement ist ein pyroelektrisches Detektorelement. Es weist einen Schichtaufbau mit zwei Elektrodenschichten und einer zwischen den Elektrodenschichten angeordneten pyroelektrischen Schicht mit pyroelektrisch sensitivem Material auf. Dieses Material ist Bleizirkonattitanat (PZT). Die Elektroden bestehen beispielsweise aus Platin oder aus einer die Wärmestrahlung absorbierenden Chrom-Nickel-Legierung.

Das thermische Detektorelement ist mit einem Detektorelement-Träger aus Silizium (Silizium-Substrat) verbunden. Zwischen dem Detektorelement und dem Detektorelement-Träger ist eine Isolationsschicht zur elektrischen und thermischen Isolierung des Detektorelements und des Detektorelement-Trägers voneinander angeordnet. Die Isolationsschicht verfügt dabei über einen evakuierten Hohlraum, der sich über eine Grundfläche des Detektorelements hinwegerstreckt, eine Stützschicht des Hohlraums und eine Abdeckung der Stützschicht und des Hohlraums. Die Stützschicht besteht aus Polysilizium. Die Abdeckung ist aus einem Bor-Phosphor-Silikat-Glas (BPSG). Zum Auslesen, Verarbeiten und/oder Weiterleiten des vom Detektorelement erzeugten elektrischen Signals ist im Detektorelement-Träger ein Ausleseschaltkreis integriert. Der Ausleseschaltkreis ist durch die CMOS (Complementary Metalloxide Semiconductors) -Technik realisiert.

Eine damit vergleichbare Vorrichtung zur Detektion von Wärmestrahlung ist aus der DE 195 25 071 A1 bekannt. Das thermische Detektorelement ist ebenfalls ein oben beschriebenes pyroelektrisches Detektorelement. Das Detektorelement ist auf einem mehrschichtigen Detektorelement-Träger angeordnet. Ein der Schichten des Detektorelement-Trägers ist eine elektrisch isolierende Membran. Die Membran besteht beispielsweise aus einer Si₃N₄/SiO₂/Si₃N₄ - Dreifach-Schicht. Die Membran ist wiederum auf einem Silizium-Substrat des Detektorelement-Trägers aufgebracht.

Bei den bekannten Vorrichtungen kann eine Vielzahl von Detektorelementen vorhanden sein (Detektorelement-Array). Um eine möglichst hohe örtliche Auflösung zu erhalten, werden die Detektorelemente möglichst nah aneinander angeordnet. Je näher aber die Detektorelemente aneinander geordnet sind, desto höher ist die Wahrscheinlichkeit für ein "Übersprechen". Die erwünschte hohe Auflösung geht verloren.

In US 2004/0113,076 ist ein Infrarotdetektor mit einer Membran beschrieben, auf der Thermoelemente vorgesehen sind. Zwischen den Thermoelementen sind Schlitze in der Membran gefertigt, um die thermische Isolation der Thermoelemente zu verbessern und somit den Cross-Talk zwischen den Thermoelementen zu reduzieren. In WO 2004/020960 ist ein Infrarotsensor mit einer Membran und darauf angebrachten Sensoren beschrieben, wobei zwischen den Sensoren auf der Membran ein Netz aus wärmeleitendem Material zum Isolieren der Sensoren vorgesehen ist, um den Cross-Talk zwischen den Sensoren zu reduzieren.

Aufgabe der Erfindung ist es, eine kompakte Vorrichtung zur Detektion von Wärmestrahlung anzugeben, wobei die Vorrichtung sowohl hohe örtliche Auflösung als auch eine niedrige Ansprechzeit hat.

Zur Lösung der Aufgabe wird eine Vorrichtung zur Detektion von Wärmestrahlung angegeben, mit einer Membran und mindestens zwei Detektorelementen, die jeweils zum Umwandeln von Wärmestrahlung in ein elektrisches Signal eingerichtet und auf der Membran nebeneinander liegend angebracht sind, wobei auf der den Detektorelementen zugewandten Seite der Membran und/oder auf der den Detektorelementen abgewandten Seite der Membran mindestens eine Wärmeableitbahn vorgesehen ist, die eine höhere Wärmeleitfähigkeit als die Membran hat und mit den Detektorelementen via die Membran wärmeleitend verbunden ist, so dass Wärme von den Detektorelementen mit der Wärmeleitbahn abführbar ist, wodurch die Ansprechzeit der Detektorelemente niedrig ist, und wobei in der Membran integriert mindestens eine Wärmebarriere vorgesehen ist, die eine niedrigere Wärmeleitfähigkeit als die Membran hat und zwischen den Detektorelementen sich erstreckt, so dass von der Wärmbarriere eine Wärmeleitung in der Membran von dem einen Detektorelement zu dem anderen Detektorelement und von einem der Detektorelemente hin zur Wärmeleitbahn hin behindert ist, wodurch das Übersprechen der Detektorelemente gering ist.

Zur Lösung der Aufgabe wird auch ein Verfahren zum Herstellen der Vorrichtung mit folgenden Verfahrenschritten angegeben: a) Bereitstellen einer Membran mit mindestens einer Wärmesenke in Form der Wärmeableitbahn zur Erzeugung eines gerichteten Wärmeflusses und mindestens einer thermischen Regelungseinrichtung in Form der Wärmebarriere zur Regulierung des Wärmeflusses und b) Anordnen der thermischen Detektorelemente auf der Membran derart, dass mittels der Wärmesenke eingerichteter Wärmefluss von mindestens einem der thermischen Detektorelemente weg in Richtung der Wärmesenke erzeugt und mittels der Regelungseinrichtung ein Ausmaß des Wärmeflusses geregelt werden kann.

Ferner kann die erfindungsgemäße Vorrichtung als Bewegungsmelder, als Präsenzmelder und/oder als Wärmebildkamera erfindungsgemäß verwendet werden.

Die zu detektierende Wärmestrahlung weist eine Wellenlänge von über 1 µm auf. Vorzugsweise ist die Wellenlänge aus dem Bereich von 5 bis 15 µm ausgewählt. Das thermische Detektorelement basiert beispielsweise auf dem Seebeck-Effekt. Vorzugsweise ist das thermische Detektorelement ein pyroelektrisches Detektorelement. Das pyroelektrische Detektorelement besteht, wie eingangs beschrieben, aus einer pyroelektrischen Schicht mit einem pyroelektrisch sensitiven Material und beidseitig angebrachten Elektrodenschichten. Das pyroelektrisch sensitive Material ist beispielsweise eine Keramik wie Lithiumniobat (LiNbO₃) oder Bleizirkonattitanat. Denkbar ist auch ein ferroelektrisches Polymer wie Polyvinylidenfluorid (PVDF). Als Elektrodenmaterial der Elektrodenschichten kommt beispielsweise Platin oder eine Platinlegierung in Frage. Denkbar ist auch eine Chrom-Nickel-Elektrode oder eine Elektrode aus einem elektrisch leitenden Oxid. Ein Detektorelement verfügt beispielsweise über eine rechteckige Grundfläche mit einer Kantenlänge von10 µm bis 200 µm. Niedriger Kantenlängen, beispielsweise 5 µm oder auch höhere Kantenlängen von bis zu 400 µm sind ebenfalls denkbar. Ein Element-Mittenabstand (Pitch) beträgt 20 µm bis 400 µm. Größere Abstände sind auch denkbar.

Die Wärmesenke in Form der Wärmeableitbahn führt zur Erzeugung des Wärmeflusses und damit zu einem Abtransport von Wärme von den Detektorelementen. Die Wärmesenke und die Detektorelemente sind thermisch leitend miteinander verbunden. Ohne zusätzliche Maßnahme würde aber durch einen damit einhergehenden erhöhten Wärmefluss eine Empfindlichkeit (Sensitivität) der Detektorelemente deutlich reduziert werden. Als Gegenmaßnahme ist die Regulierungseinrichtung in Form der Wärmebarriere vorhanden. Mit Hilfe der Regulierungseinrichtung wird der das Ausmaß (Größe) des Wärmeflusses eingestellt. Die Regulierungseinrichtung fungiert als thermischer Widerstand. Dadurch gelingt es, die Empfindlichkeit der Detektorelemente aufrecht zu halten.

Das Detektorelement und das weitere Detektorelement sind nebeneinander auf einem Oberflächenabschnitt eines gemeinsamen Detektorelement-Trägers angeordnet, der von der Membran gebildet ist. Dadurch, dass das thermische Übersprechen bzw. die thermische Kopplung zwischen den Detektorelementen effizient unterbunden wird, können die Detektorelemente sehr nah aneinander angeordnet werden.

Die Wärmesenke ist zwischen dem thermischen Detektorelement und dem weiteren thermischen Detektorelement angeordnet. In dieser Konstellation wird die vom Detektorelement und vom benachbarten weiteren Detektorelement abgegebene Wärme abgeleitet. Es kommt zu keinem thermischen Übersprechen zwischen den Detektorelementen.

Vorzugsweise ist die Wärmesenke auf dem Oberflachenabschnitt angeordnet, auf dem die Detektorelemente angeordnet sind. Alternativ dazu ist die Wärmesenke an einer dem Oberflächenabschnitt abgekehrten Seite des Detektorelement-Trägers angeordnet. Die Wärmesenke ist an der Rückseite des Detektorelement-Trägers angeordnet. Denkbar ist auch, dass die Wärmesenke beidseitig, also auf der Detektorelement-Seite oder auf der abgekehrten Seite des Detektorelement-Trägers angeordnet ist.

Die Wärmeableitbahn ist bevorzugt aus Silizium. Der gemeinsame Detektorelement-Träger weist die Membran auf, die den Oberflächenabschnitt bildet, auf dem die Detektorelemente angeordnet sind. Die Membran besteht aus einer Membranschicht oder aus mehreren Membranschichten. Dabei kann eine Vielzahl von anorganischen oder organischen Materialien eingesetzt werden. Beispielsweise ist die Membranschicht aus Siliziumdioxid (SiO₂) oder Siliziumnitrid (Si₃N₄). Der besondere Vorteil an Schichten aus diesen Materialien liegt in der elektrischen und thermischen Isolationswirkung der Materialien. Diese Materialien fungieren als elektrischer und thermischer Isolator.

Bevorzugt ist die Wärmeableitbahn als ein Steg ausgebildet, der an der Membran angeordnet ist. Ferner ist es bevorzugt, dass die Wärmeableitbahn von einer Mehrzahl der Stege gebildet ist, die einen Bereich der Membran umschließen, in dem mindestens eines der Detektorelemente angeordnet ist. Die Wärmesenke und/oder die Regelungseinrichtung sind jeweils ein Bestandteil des gemeinsamen Detektorelement-Trägers. Dies gelingt insbesondere dadurch, dass die Wärmesenke mindestens einen auf dem gemeinsamen Detektorelement-Träger angeordneten Steg mit thermisch leitfähigem Material aufweist. Der Steg oder die Stege können auf der Vorderseite und auf der Rückseite angeordnet werden. Über die Stege wird die Wärme effizient in Richtung der Wärmesenke abgeleitet. Die Stege erfüllen zudem eine Stützfunktion: Eine mechanische Stabilität der Vorrichtung wird erhöht. Dies ist insbesondere im Hinblick auf die Herstellung der Vorrichtung mit Waferbond-Prozessen von Vorteil.

Alternativ ist bevorzugt die Wärmeableitbahn von einer Dünnschicht gebildet, die an der Membran angeordnet ist. Somit ist die Wärmesenke bevorzugt die auf dem Detektorelement-Träger aufgebrachte Dünnschicht mit thermischleitfähigem Material. Der Detektorelement-Träger ist beispielsweise eine eingangs erwähnte mehrschichtige Membran. In diese mehrschichtige Membran kann eine Schicht als thermisch gut leitfähigem Material integriert sein. Über diese Schicht, die wiederum mit einer Wärmesenke thermisch leitend verbunden ist, wird die Wärme gerichtet abgeleitet. Als thermisch leitfähiges Material des Stegs oder einer Dünnschicht sind beliebige Materialien denkbar. Vorzugsweise ist das thermisch leitfähige Material Silizium, wie es in der CMOS-Technologie bevorzugt zum Einsatz kommt.

Die Wärmebarriere ist bevorzugt eine in der Membran vorgesehene, evakuierte Aussparung. Die Regelungseinrichtung weist somit bevorzugt eine Ausnehmung des Detektorelement-Trägers auf. Denkbar ist beispielsweise eine Ausdünnung des Detektorelement-Trägers oder ein Loch im Detektorelement-Träger. Durch die Aussparung ist ein Wärmequerschnitt des Detektorelement-Trägers im Vergleich zu einem Detektorelement-Träger ohne Aussparung reduziert. Es kommt zu einer Reduzierung eines lateralen Wärmetransfers. Dies führt dazu, dass der Wärmefluss von einem Detektorelement hin zur Wärmesenke behindert ist. In Folge davon bleibt die Empfindlichkeit des Detektorelements bzw. der Detektorelemente weitestgehend aufrechterhalten.

Die evakuierte Aussparung ist bevorzugt ein in der Membran vorgesehener Schlitz, der zwischen zwei benachbarten Detektorelementen senkrecht zu einer gedachten, von den beiden Detektorelementen definierten Verbindungslinie verläuft. Es ist bevorzugt, dass mindestens zwei parallel zueinander und auf gleicher Höhe verlaufende Schlitze vorgesehen sind, so dass die Schlitze zwischen den Detektorelementen angeordnet sind. Außerdem ist es bevorzugt, dass die Wärmeableitbahn zwischen den Schlitzen verläuft, so dass die Wärmeableitbahn durch die Schlitze von den Detektorelementen thermisch isoliert ist.

Die Detektorelemente sind auf der Membran befestigt und stehen mit ihr in wärmeleitendem Kontrakt. Daher sind die Detektorelemente miteinander via die Membran wärmeleitend gekoppelt. Die Wärmeleitung durch die Membran von dem einen Detektorelement zu dem anderen Detektorelement ist von dem Wärmeleitungskoeffizienten der Membran und der Membrandicke definiert. Dadurch, dass zwischen den Detektorelementen die Wärmebarriere angeordnet ist, sind die Detektorelemente hinsichtlich ihres Wärmeaustauschs durch die Membran thermisch voneinander isoliert. Dadurch ist ein Übersprechen der Detektorelemente aufgrund vom Wärmeaustausch reduziert. Somit ist die örtliche Auflösung der Vorrichtung hoch, obwohl die Bestückungsdichte der Membran mit den Detektorelementen hoch ist. Ferner erwärmt sich das Detektorelement durch die Wärmestrahlung rasch, da aufgrund der Isolationswirkung der Wärmebarriere nur wenig Wärme von dem Detektorelement durch die Membran abgeleitet wird. Dadurch ist der Anstieg des elektrischen Signals im Zeitpunkt des Auftreffens der Wärmestrahlung auf das Detektorelements steil. Nachteilig hierbei ist allerdings, dass aufgrund der Isolationswirkung der Wärmebarriere das Detektorelement bei Beendigung der Wärmeeinstrahlung durch Wärmeabfuhr über die Membran nur langsam abkühlt. Die hätte zur Folge, dass die Ansprechzeit des Detektorelements lang wäre. Abhilfe schafft das Vorsehen der Wärmeableitbahn, mit der Wärme von dem Detektorelement rasch abgeleieinstrahlung durch Wärmeabfuhr über die Wärmeableitbahn schnell abkühlt. Dadurch ist der Abfall des elektrischen Signals im Zeitpunkt des Ausbleibens der Wärmestrahlung auf das Detektorelements steil. Somit ist die Ansprechzeit der Vorrichtung niedrig, obwohl die Vorrichtung eine hohe Bestückungsdichte mit den Detektoren hat.

Gemäß dem weiteren Aspekt der Erfindung wird die Vorrichtung als Bewegungsmelder, als Präsenzmelder und/oder als Wärmebildkamera verwendet. Für die Wärmebildkamera ist die Vorrichtung mit einer Vielzahl von Detektorelementen, beispielsweise 240 X 320 Detektorelemente (QVGA-Standard) und mehr ausgestattet. Dies ist aufgrund der hohen Integrationsdichte (Anzahl der Detektorelemente pro Flächeneinheit) möglich.

Zusammenfassend sind folgende Vorteile der Erfindung hervorzuheben:
- Die Vorrichtung zur Detektion von Wärmestrahlung ist kompakt.
- Durch die Erfindung ist eine im Vergleich zum Stand der Technik erhöhte Integrationsdichte.
- Eine Übersprechwahrscheinlichkeit zwischen benachbarten Detektorelementen ist reduziert. Gleichzeitig bleibt aber die Sensitivität (Empfindlichkeit) der einzelnen Detektorelemente erhalten.
- Die Vorrichtung ist insbesondere bei Verwendung von Stegen mechanisch stabilisiert.

Anhand eines Ausführungsbeispiels und der dazugehörigen Figuren wird im Folgenden die Vorrichtung zur Detektion von Wärmestrahlung vorgestellt. Die Figuren sind schematisch und stellen keine maßstabsgetreuen Abbildungen dar.

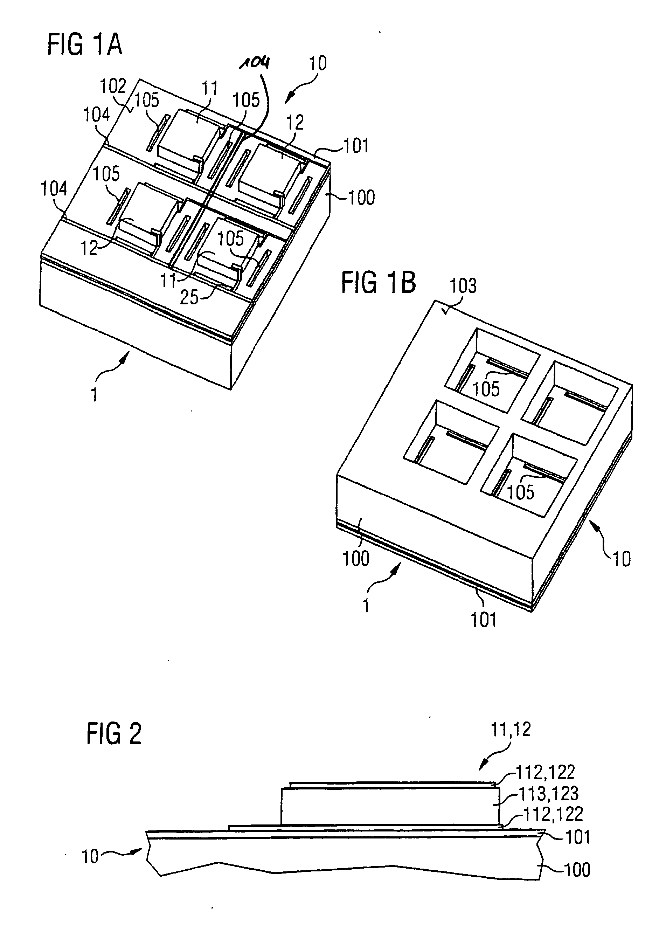

Figur 1A zeigt eine Vorrichtung zur Detektion von Wärmestrahlung in perspektivischer Darstellung von oben.

Figur 1B zeigt eine Vorrichtung zur Detektion von Wärmestrahlung in perspektivischer Darstellung von unten.

Figur 1B zeigt eine Vorrichtung zur Detektion von Wärmestrahlung in perspektivischer Darstellung von unten.

Figur 2 zeigt ein Detektorelement auf einem Detektorelement-Träger in einem seitlichen Querschnitt.

Die Vorrichtung 1 zur Detektion von Wärmestrahlung weist einen Detektorelement-Träger 10 mit einer Membran 101 auf, auf der ein thermisches Detektorelement 11 und mindestens ein weiteres thermisches Detektorelement 12 aufgebracht sind. Der Detektorelement-Träger weist ein Silizium-Substrat 100 auf. Die thermischen Detektorelemente sind zu einem Detektorelement-Array 110 auf dem Oberflächenabschnitt 102 der Membran angeordnet. Beispielhaft ist in Figur 1A ein Detektorelement-Array mit 2x2 Detektorelementen gezeigt.

Die Detektorelemente 11 und 12 sind pyroelektrische Detektorelemente in Dünnschichtbauweise mit zwei Elektrodenschichten 112 und 122 und jeweils einer zwischen den Elektrodenschichten angeordneten pyroelektrischen Schicht 113 und 123 (Figur 2). Die pyroelektrische Schicht ist jeweils eine Ca. 1 µm dicke Schicht aus PZT als pyroelektrisch sensitives Material. Die Elektrodenschichten sind aus Platin und einer Chrom-NickelLegierung mit Schichtdicken von etwa 20 nm.

Die Membran 101 ist eine Si₃N₄/SiO₂/Si₃N₄ - Dreifach-Schicht. Für die Detektorelemente ist im Silizium-Substrat des Detektorelement-Trägers eine nicht dargestellte Auslesschaltung integriert.

Zwischen den Detektorelementen sind dünne Stege 104 aus Silizium sowohl auf der Vorderseite 102 als auch auf der Rückseite 103 angeordnet. Die dünnen Stege fungieren als jeweils als Wärmesenke von zumindest einem der Detektorelemente weg zu einer Wärmesenke hin. Die Wärmesenke ist nicht dargestellt.

Darüber hinaus sind Ausnehmungen in Form von Schlitzen 105 in der Membran enthalten. Die Schlitze fungieren als Regulierungseinrichtungen zur Regulierung des jeweiligen Wärmeflusses. Finite Element (FEM) - Simulationen des thermischen Überkoppelns am Beispiel von Detektorelementen mit einer Grundfläche von 200x200µm2 bei einem Abstand der Detektorelemente von 400µm voneinander haben die Wirksamkeit der erfinderischen Kombination von Schlitz und Steg bestätigt:

| Basisstruktur | Auf Basisstruktur normierte Empfindlichkeit | Übersprechen zwischen benachbarten Pixeln |
|---|---|---|
| ohne Stege + Schlitze | 1 | 33% |
| mit Stege | 0,28 | < 1% |
| mit Stege + Schlitze | 0,82 | < 1% |
| mit Stege + Schlitze und Basistruktur auf 1/4 verkleinert | 2,4 | < 1% |

Zum Herstellen der Vorrichtung wird wie folgt vorgegangen: a) Bereitstellen eines Detektorelement-Trägers mit einem Oberflächenabschnitt, mindestens einer Wärmesenke zur Erzeugung eines gerichteten Wärmeflusses und mindestens einer thermischen Regelungseinrichtung zur Regulierung des Wärmeflusses und b) Anordnen der thermischen Detektorelemente auf dem Oberflächenabschnitt des Detektorelement-Träger derart, dass mittels der Wärmesenke ein gerichteter Wärmefluss von mindestens einem der thermischen Detektorelemente weg in Richtung der Wärmesenke erzeugt und mittels der Regelungseinrichtung ein Ausmaß des Wärmeflusses geregelt werden kann. Auf dem Oberflächenabschnitt des vorgefertigten Detektorelement-Trägers werden die Detektorelemente aufgebracht. Alternativ dazu wird zunächst ein Detektorelement-Träger mit den Stegen bereitgestellt. Das Einbringen der Schlitze (Regulierungseinrichtung) erfolgt nach dem Anordnen der Detektorelemente. Das Anordnen der Detektorelemente erfolgt in üblicher Weise, beispielsweise durch Sputtern der einzelnen Schichten.

Nach dem Anordnen wird üblicherweise ein sogenanntes Rückseiten-Ätzen durchgeführt. Material des Silizium-Substrats wird von der Rückseite abgetragen, also der Seite des Silizium-Substrats, die den Detektorelementen abgekehrt ist. Dabei werden die Schlitze freigelegt werden.

Verwendung findet die Vorrichtung in einem Bewegungsmelder, einem Präsenzmelder oder einer Wärmebildkamera.

## Patentansprüche

1. Vorrichtung zur Detektion von Wärmestrahlung, mit einer Membran (101) und mindestens zwei Detektorelementen (11, 12), die jeweils zum Umwandeln von Wärmestrahlung in ein elektrisches Signal eingerichtet und auf der Membran (101) nebeneinander liegend angebracht sind, wobei auf der den Detektorelementen (11, 12) zugewandten Seite der Membran (100) und/oder auf der den Detektorelementen (11, 12) abgewandten Seite der Membran (100) mindestens eine Wärmesenke in Form einer Wärmeableitbahn (104) angeordnet ist, die eine höhere Wärmeleitfähigkeit als die Membran (101) hat und mit den Detektorelementen (11, 12) via die Membran (101) thermisch leitend verbunden ist, so dass Wärme von den Detektorelementen (11, 12) mit der Wärmeableitbahn (104) abführbar ist, wodurch die Ansprechzeit der Detektorelemente (11, 12) niedrig ist, und wobei in der Membran (101) integriert mindestens zwei Wärmebarrieren (105) angeordnet sind, die eine niedrigere Wärmeleitfähigkeit als die Membran (101) haben und zwischen den Detektorelementen (11, 12) sich so erstrecken, dass von der Wärmebarriere (105) eine Wärmeleitung in der Membran (101) von dem einen Detektorelement (11, 12) zu dem anderen Detektorelement (11, 12) und von den Detektorelementen (11, 12) hin zur Wärmeleitbahn (104) behindert ist, wodurch das Übersprechen der Detektorelemente (11, 12) gering ist, wobei die Wärmebarrieren (105) mindestens zwei parallel zueinander und auf gleicher Höhe verlaufende, in der Membran (101) angeordnete und evakuierte Schlitze (105) sind, die zwischen zwei benachbarten Detektorelementen (11, 12) senkrecht zu einer gedachten, von den beiden Detektorelementen (11, 12) definierten Verbindungslinie verlaufen, so dass die Schlitze (105) zwischen den Detektorelementen (11, 12) angeordnet sind, wobei die Wärmeableitbahn (104) zwischen den Schlitzen (105) verläuft, wodurch die Wärmeableitbahn (104) durch die Schlitze (105) von den Detektorelementen (11, 12) thermisch isoliert ist.

2. Vorrichtung gemäß Anspruch 1, wobei die Wärmeableitbahn (104) aus Silizium ist.

3. Vorrichtung gemäß Anspruch 2, wobei die Wärmeableitbahn als ein Steg (104) ausgebildet ist, der an der Membran (101) angeordnet ist.

4. Vorrichtung gemäß Anspruch 3, wobei die Wärmeableitbahn von einer Mehrzahl der Stege (104) gebildet ist, die einen Bereich der Membran (101) umschließen, in dem mindestens eines der Detektorelemente (11, 12) angeordnet ist.

5. Vorrichtung gemäß Anspruch 1 oder 2, wobei die Wärmeableitbahn (104) von einer Dünnschicht gebildet ist, der auf der Membran (101) angeordnet ist.

6. Verfahren zum Herstellen einer Vorrichtung nach einem der Anspruche 1 bis 5, mit folgenden Verfahrensschritten:
a) Bereitstellen einer Membran (101) mit der Wärmesenke in Form der Wärmeableitbahn (104) zur Erzeugung eines gerichteten Wärmeflusses und mindestens einer thermischen Regelungseinrichtung in Form der Wärmebarrieren (105) zur Regulierung des Wärmeflusses und
b) Anordnen der thermischen Detektorelemente (11, 12), der Wärmeleitbahn (104) und der Wärmesenken (105) auf der Membran (101) derart, dass die Wärmebarrieren (105) mindestens zwei parallel zueinander und auf gleicher Höhe verlaufende, in der Membran (101) angeordnete und evakuierte Schlitze (105) sind, die zwischen zwei benachbarten Detektorelementen (11, 12) senkrecht zu einer gedachten, von den beiden Detektorelementen (11, 12) definierten Verbindungslinie verlaufen, so dass die Schlitze (105) zwischen den Detektorelementen (11, 12) angeordnet sind, wobei die Wärmeableitbahn (104) zwischen den Schlitzen (105) verläuft, so dass mittels der Wärmesenke ein gerichteter Wärmefluss von mindestens einem der thermischen Detektorelemente weg in Richtung der Wärmesenke erzeugt und mittels der Regelungseinrichtung ein Ausmaß des Wärmeflusses geregelt werden kann.

7. Verwendung einer Vorrichtung nach einem der Ansprüche 1 bis 5 als Bewegungsmelder, als Präsenzmelder und/oder als Wärmebildkamera.

## Claims

1. Device to detect thermal radiation, with a membrane (101) and at least two detector elements (11, 12) that are respectively set up to transduce thermal radiation into an electrical signal and are mounted situated next to one another on the membrane (101), wherein at least one heat sink in shape of a heat dissipation path (104) is provided on the side of the membrane (100) facing towards the detector elements (11, 12) and/or on the side of the membrane (100) facing away from the detector elements (11, 12), which heat dissipation path (104) has a higher heat conductivity than the membrane (101) and is connected with the detector elements (11, 12) in a heat-conductive manner via the membrane (101) so that heat can be discharged from the detector elements (11, 12) with the heat dissipation path (104), whereby the response time of the detector elements (11, 12) is low; and wherein at least two heat barriers (105) are provided integrated into the membrane (101), which heat barriers (105) have a lower heat conductivity than the membrane (101) and extend between the detector elements (11, 12) such that a heat conduction in the membrane (101) from the one detector element (11, 12) to the other detector element (11, 12) and from the detector elements (11, 12) to the heat dissipation path (104) is prevented by the heat barrier (105); whereby the crosstalk of the detector elements (11, 12) is low, wherein the heat barriers (105) are at least two evacuated slits (105) provided in the membrane (101), running parallel to one another and at the same level and running between two adjacent detector elements (11, 12), perpendicular to an imaginary connection line defined by the two detector elements (11, 12) so that the slits (105) are arranged between the detector elements (11, 12), wherein the heat dissipation path (104) runs between the slits (105), whereby the heat dissipation path (104) is thermally insulated from the detector elements (11, 12) by the slits (105).

2. Device according to Claim 1, wherein the heat conduction path (104) is made of silicon.

3. Device according to Claim 2, wherein the heat conduction path is fashioned as a web (104) that is arranged on the membrane (101).

4. Device according to Claim 3, wherein the heat conduction path is formed from a plurality of webs (104) that surround a region of the membrane (101) in which is arranged at least one of the detector elements (11, 12).

5. Device according to Claim 1 or 2, wherein the heat conduction path (104) is formed by a thin film that is arranged on the membrane (101).

6. Method to produce a device according to any of the Claims 1 through 5, with the following method steps:
a) provide a membrane (101) with the heat sink in the form of the heat dissipation path (104) to generate a directed heat flow and at least one thermal regulation device in the form of the heat barrier (105) to regulate the heat flow and
b) arrange the thermal detector elements (11, 12), the heat dissipation path (104) and the heat sinks (105) on the membrane (101) such that the heat barriers (105) are at least two evacuated slits (105) provided in the membrane (101) and running parallel to one another and at the same level, which slits run between two adjacent detector elements (11, 12), perpendicular to an imaginary connection line defined by the two detector elements (11, 12) so that the slits (105) are arranged between the detector elements (11, 12), wherein the heat dissipation path (104) runs between the slits (105), so that a directed heat flow away from at least one of the thermal detector elements in the direction of the heat sink can be generated by means of the heat sink, and a magnitude of the heat flow can be regulated by means of the regulation device.

7. Use of a device according to any of the Claims 1 through 5 as a movement sensor, as a presence sensor and/or as a heat image camera.

## Revendications

1. Dispositif de détection d'un rayonnement thermique, comprenant une membrane (101) et au moins deux éléments de détection (11, 12) qui sont chacun conçus pour transformer un rayonnement thermique en un signal électrique et sont installés de manière adjacente sur la membrane (101), étant entendu qu'il est agencé sur le côté de la membrane (100) dirigé vers les éléments de détection (11, 12) eUou sur le côté de la membrane (100) opposé aux éléments de détecteur (11, 12), au moins un puits thermique sous la forme d'un chemin de dissipation de la chaleur (104) qui a une conductibilité thermique plus élevée que la membrane (101) et qui est relié aux éléments de détection (11, 12) par le biais de la membrane (101) de telle sorte que la chaleur des éléments de détection (11, 12) peut être évacuée par le chemin de dissipation de la chaleur (104) afin que le temps de réponse des éléments de détection (11, 12) demeure faible, et étant entendu qu'au moins deux barrières thermiques (105) sont intégrées dans la membrane (101), lesquelles ont une conductibilité thermique moins élevée que la membrane (101) et s'étendent entre les éléments de détection (11, 12) de telle sorte qu'une conduction thermique dans la membrane (101) depuis un élément de détection (11, 12) vers l'autre élément de détection (11, 12) et depuis les éléments de détection (11, 12) en direction du chemin de dissipation de la chaleur (104) est empêchée par les barrières thermiques (105), ce qui permet de garder une faible diaphonie des éléments de détection (11, 12), étant entendu que les barrières thermiques (105) sont deux fentes (105) pratiquées dans la membrane (101) qui s'étendent parallèlement l'une à l'autre et à la même hauteur, et qui s'étendent perpendiculairement à une ligne de jonction imaginaire entre les deux éléments de détection (11, 12) adjacents, de telle sorte que les fentes (105) sont agencées entre les éléments de détection (11, 12), étant entendu que le chemin de dissipation de la chaleur (104) s'étend entre les fentes (105), ce qui a pour effet d'isoler thermiquement le chemin de dissipation de la chaleur (104) des éléments de détection (11, 12) grâce aux fentes (105).

2. Dispositif selon la revendication 1, **caractérisé en ce que** le chemin de dissipation de la chaleur (104) est en silicium.

3. Dispositif selon la revendication 2, **caractérisé en ce que** le chemin de dissipation de la chaleur est une rainure (104) qui est agencée sur la membrane (101).

4. Dispositif selon la revendication 3, **caractérisé en ce que** le chemin de dissipation de la chaleur est réalisé par une pluralité de rainures (104) qui entourent une zone de la membrane (101) dans laquelle au moins l'un des éléments de détection (11, 12) est agencé.

5. Dispositif selon la revendication 1 ou la revendication 2, **caractérisé en ce que** le chemin de dissipation de la chaleur (104) est un film mince qui est appliqué sur la membrane (101).

6. Procédé de production d'un dispositif selon l'une des revendications 1 à 5, **caractérisé en ce qu'**il comprend les étapes suivantes :
a) préparation d'une membrane (101) comprenant le puits thermique sous la forme d'un chemin de dissipation de la chaleur (104) aux fins de la réalisation d'un flux thermique orienté et d'au moins un dispositif de régulation thermique sous la forme de barrières thermiques (105) aux fins de la régulation du flux thermique, et
b) agencement des éléments de détection thermiques (11, 12), du chemin de dissipation de la chaleur (104) et du puits thermique (105) sur la membrane (101) de telle sorte que les barrières thermiques (105) qui sont au moins deux fentes (105) pratiquées dans la membrane (101) s'étendent parallèlement l'une et l'autre et à la même hauteur, qui s'étendent perpendiculairement à une ligne de jonction imaginaire définie par les deux éléments de détection (11, 12), de telle sorte que les fentes (105) sont agencées entre les éléments de détection (11, 12), étant entendu que le chemin de dissipation de la chaleur (104) s'étend entre les fentes (105), de telle sorte qu'est produit au moyen du puits thermique un flux thermique orienté depuis au moins l'un des éléments de détection thermiques en direction du puits thermique, et que l'intensité du flux thermique peut être régulée au moyen de ce dispositif de régulation.

7. Utilisation d'un dispositif selon l'une des revendications 1 à 5 comme détecteur de mouvement, comme détecteur de présence et/ou comme caméra thermique.
